# EUROPÄISCHE PATENTANMELDUNG

(11) **EP 3 068 010 A1**
(43) Veröffentlichungstag der Anmeldung: **14.09.2016**
(21) Anmeldenummer: 15158344.0
(22) Anmeldetag: 10.03.2015
(51) Int. Cl.: H02J 7/00

(54) **Netzbetreibbares Akku-Ladegerät und Ladesystem**

(71) Anmelder: HILTI Aktiengesellschaft, 9494 Schaan (LI)
(72) Erfinder: Wagner, Michael, 87648 Aitrang (DE)
(74) Vertreter: Hilti Aktiengesellschaft Corporate Intellectual Property

(57) **Zusammenfassung**

Netzbetreibbares Akku-Ladegerät (100) mit einem Ladergehäuse (90), das eine zur auswechselbaren Aufnahme eines Haupt-Werkzeugakkus (10) einer Handwerkzeugmaschine ausgebildete Hauptladeschnittstelle (80) aufweist, und mit einer Ladeelektronik (70) die innerhalb des Ladergehäuses (90) angeordnet und ausgebildet ist, einen in der Hauptladeschnittstelle (80) aufgenommenen Haupt-Werkzeugakku (10) mit einer Hauptladespannung (U10) zu laden, dadurch gekennzeichnet, dass das Akku-Ladegerät (100) wenigstens eine Nebenladeschnittstelle (21, 31) aufweist, über die ein Neben-Werkzeugakku (20, 30) mit dem Akku-Ladegerät (100) verbindbar und mit einer von der Hauptladespannung (U10) verschiedenen Nebenladespannung (U20, 30) ladbar ist.

## Beschreibung

Die vorliegende Erfindung betrifft ein netzbetreibbares Akku-Ladegerät mit einem Ladegehäuse, das eine zur auswechselbaren Aufnahme eines Haupt-Werkzeugakkus einer Handwerkzeugmaschine, beispielsweise eines Bohrhammers oder Kombihammers, ausgebildete Hauptladeschnittstelle aufweist. Das Akku-Ladegerät weist weiter eine Ladeelektronik auf, die innerhalb des Ladergehäuses angeordnet und ausgebildet ist, einen in der Hauptladeschnittstelle aufgenommenen Haupt-Werkzeugakku mit einer Hauptladespannung zu laden. Die vorliegende Erfindung betrifft ebenfalls ein Ladesystem mit einem netzbetreibbaren Akku-Ladegerät und einem Haupt-Werkzeugakku.

Es ist Aufgabe der vorliegenden Erfindung, ein netzbetreibbares Akku-Ladegerät und ein Ladesystem anzugeben, die vielseitig einsetzbar sind. Bezüglich des Akku-Ladegeräts wird die Aufgabe dadurch gelöst, dass das Akku-Ladegerät wenigstens eine Nebenladeschnittstelle aufweist, über die ein Neben-Werkzeugakku mit dem Akku-Ladegerät verbindbar und mit einer von der Hauptladespannung verschiedenen Nebenladespannung ladbar ist.

Haupt-Werkzeugakku und Neben-Werkzeugakku können verschiedenen Typs sein, insbesondere können Haupt-Werkzeugakku und Neben-Werkzeugakku zum Betrieb von Handwerkzeugmaschinen verschiedenen Typs ausgebildet und/oder bestimmt sein.

Die Erfindung schließt die Erkenntnis ein, dass Haupt-Werkzeugakkus und Neben-Werkzeugakkus, insbesondere, wenn sie verschiedenen Typs sind, bisher nicht über ein und dasselbe Akku-Ladegerät geladen werden konnten. So ist es beispielsweise mit Akku-Ladegeräten des Standes der Technik unmöglich, gleichzeitig zu einem Haupt-Werkzeugakku mit einer Nennspannung von 36 Volt gleichzeitig einen Neben-Werkzeugakku mit einer Nennspannung von 14 Volt oder 22 Volt zu laden.

Durch das erfindungsgemäße netzbetreibbare Akku-Ladegerät kann in Abkehr zum Stand der Technik nun vorteilhafterweise ein in der Hauptladeschnittstelle aufgenommener Haupt-Werkzeugakku mit einer Hauptladespannung geladen werden und gleichzeitig ein Neben-Werkzeugakku mit einer von der Hauptladespannung verschiedenen Nebenladespannung.

In einer bevorzugten Ausgestaltung sind die zur Aufnahme des Haupt-Werkzeugakkus ausgebildete Hauptladeschnittstelle und die mit einem Neben-Werkzeugakku verbindbaren Nebenladeschnittstelle mechanisch verschieden kodiert, wobei insbesondere Haupt-Werkzeugakku und Neben-Werkzeugakku verschiedenen Typs sind. Mit anderen Worten ist also die Hauptladeschnittstelle, insbesondere lediglich zur Aufnahme des Haupt-Werkzeugakkus ausgebildet und insbesondere nicht zur Aufnahme eines typverschiedenen Neben-Werkzeugakkus.

In einer besonders bevorzugten Ausgestaltung ist die Nebenladeschnittstelle als Stecker zum Aufstecken auf einen Neben-Werkzeugakku ausgebildet. Die Erfindung schließt diesbezüglich die Erkenntnis ein, dass an Akku-Ladegeräten des Standes der Technik bisher nur ein Haupt-Werkzeugakku und keine typverschiedenen Neben-Werkzeugakkus geladen werden können. So ist es beispielsweise bisher nicht möglich gewesen, zu einem Haupt-Werkzeugakku mit einer Nennspannung von 36 Volt und einer ersten Hardwarekodierung gleichzeitig einen Neben-Werkzeugakku mit einer Nennspannung von 14 Volt oder 22 Volt mit einer Hardwarekodierung, die von der Hardwarekodierung des Haupt-Werkzeugakkus verschieden ist, zu laden.

Dadurch, dass die Nebenladeschnittstelle bevorzugt als Stecker zum Aufstecken auf einen Neben-Werkzeugakku ausgebildet ist, kann dieser nun, obwohl er insbesondere mechanisch verschieden kodiert ist, gleichzeitig zu einem Haupt-Werkzeugakku geladen werden. Eine Ausgestaltung des Akku-Ladegeräts mit verschiedentlich hardware-kodierten Hauptladeschnittstellen ist nun nicht mehr erforderlich. Mit anderen Worten kann ein netzbetreibbares Akku-Ladegerät lediglich zur Aufnahme genau eines mechanisch kodierten Haupt-Werkzeugs ausgebildet sein und ein Laden eines verschieden kodierten Neben-Werkzeugakkus über einen entsprechenden Stecker erfolgen.

Das Akku-Ladegerät kann eine, zwei oder drei oder mehrere Nebenladeschnittstellen aufweisen. Bevorzugt weist das Akku-Ladegerät genau zwei Nebenladeschnittstellen auf. Das Akku-Ladegerät kann genau eine Nebenladeschnittstelle aufweisen.

Bevorzugt ist die Hauptladespannung zum Laden eines Haupt-Werkzeugakkus mit einer Nennspannung von 36 Volt eingerichtet. Ebenfalls bevorzugt ist die Nebenladespannung zum Laden eines Werkzeugakkus mit einer Nennspannung von 14 Volt oder 22 Volt eingerichtet. Eine erste Nebenladespannung kann zum Laden eines Werkzeugakkus mit einer Nennspannung von 14 Volt eingerichtet sein. Eine zweite Nebenladespannung kann zum Laden eines Werkzeugakkus mit einer Nennspannung von 22 Volt eingerichtet sein. Umgekehrt kann eine erste Nebenladespannung zum Laden eines Werkzeugakkus mit einer Nennspannung von 22 Volt eingerichtet sein. Eine zweite Nebenladespannung kann zum Laden eines Werkzeugs mit einer Nennspannung von 14 Volt eingerichtet sein.

In einer besonders bevorzugten Ausgestaltung ist die Hauptladespannung zum Laden eines Haupt-Werkzeugakkus mit einer Nennspannung von 36 Volt eingerichtet und die Hauptladeschnittstelle zur Aufnahme eines Haupt-Werkzeugakkus mit 36 Volt ausgebildet beziehungsweise mechanisch kodiert. Alternativ kann die Hauptladespannung zum Laden eines Haupt-Werkzeugakkus mit einer Nennspannung von 14 Volt oder 22 Volt ausgebildet sein und die Hauptladeschnittstelle zur Aufnahme eines Haupt-Werkzeugakkus mit einer Nennspannung von 14 Volt oder 22 Volt ausgebildet sein.

Die Nebenladeschnittstelle kann elektrisch mit der gleichen Ladeelektronik wie die Hauptladeschnittstelle verbunden sein. Bevorzugt ist genau eine Ladeelektronik sowohl für die Hauptladeschnittstelle als auch die Nebenladeschnittstelle/die Nebenladeschnittstellen vorgesehen.

Bevorzugt ist die Nebenladeschnittstelle über ein Nebenladekabel an das Akku-Ladegerät, insbesondere dessen Ladeelektronik angebunden. Eine erste Nebenladeschnittstelle kann über ein erstes Nebenladekabel an das Akku-Ladegerät, insbesondere dessen Ladeelektronik angebunden sein. Eine zweite Nebenladeschnittstelle kann über ein zweites Nebenladekabel an das Akku-Ladegerät, insbesondere dessen Ladeelektronik angebunden sein.

Es hat sich als vorteilhaft herausgestellt, wenn das Akku-Ladegerät einen innerhalb des Ladegehäuses zum Kühlen der Ladeelektronik angeordneten Kühlungslüfter aufweist.

Die Hauptladeschnittstelle kann wenigstens einen Lüftungskanal aufweisen, über den ein in der Hauptladeschnittstelle aufgenommener Haupt-Werkzeugakku mittels durch den Kühlungslüfter angesaugter Luft kühlbar ist. Der Haupt-Werkzeugakku kann seinerseits einen Akkulüftungskanal aufweisen, über den der Haupt-Werkzeugakku mit Luft durchströmbar ist.

Bezüglich des Ladesystems wird die Aufgabe gelöst durch ein vorbeschriebenes netzbetreibbares Akku-Ladegerät und einem Haupt-Werkzeugakku, zu dessen Aufnahme die Hauptladeschnittstelle des netzbetreibbaren Akku-Ladegeräts ausgebildet ist. Bevorzugt ist die Hauptladeschnittstelle ausschließlich mechanisch auf den Haupt-Werkzeugakku kodiert, insbesondere weist der Haupt-Werkzeugakku eine Nennspannung von 36 Volt auf.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

In den Figuren sind gleiche und gleichartige Komponenten mit gleichen Bezugszeichen beziffert.

Es zeigen:
- Fig. 1: eine schematische Darstellung eines ersten Ausführungsbeispiels eines erfindungsgemäßen netzbetreibbaren Akku-Ladegeräts;
- Fig. 2: eine schematische Darstellung eines zweiten Ausführungsbeispiels eines erfindungsgemäßen netzbetreibbaren Akku-Ladegeräts;
- Fig. 3: eine schematische Darstellung eines dritten Ausführungsbeispiels eines erfindungsgemäßen netzbetreibbaren Akku-Ladegeräts.

### Ausführungsbeispiele:

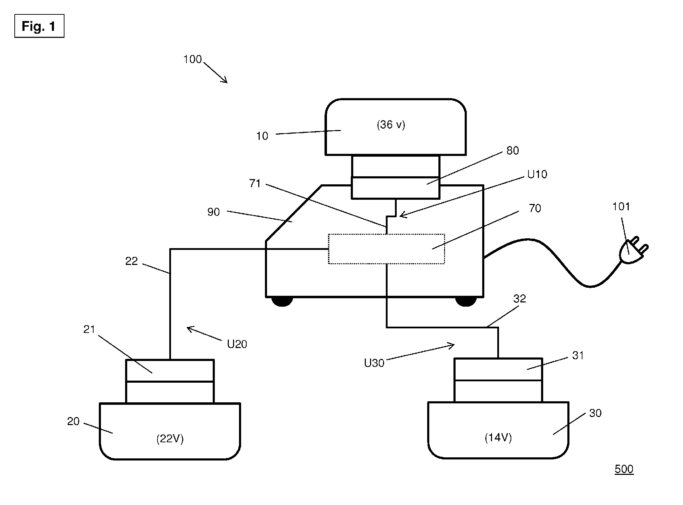

Fig. 1 zeigt ein netzbetreibbares Akku-Ladegerät 100 mit einem Ladergehäuse 90, das eine zur auswechselbaren Aufnahme eines Haupt-Werkzeugakkus 10 einer Handwerkzeugmaschine ausgebildete Hauptladeschnittstelle 80 aufweist. Der vorliegend in der Hauptladeschnittstelle 80 aufgenommene Haupt-Werkzeugakku 10 weist eine Nennspannung von 36 Volt auf. Entsprechend ist die Hauptladeschnittstelle 80 zur Aufnahme des Haupt-Werkzeugakkus mit 36 Volt ausgebildet und mechanisch kodiert. Das netzbetreibbare Akku-Ladegerät 100 kann über einen Netzstecker 101 beispielsweise mit einem 230-Volt-Wechselspannungsnetz verbunden werden.

Das Akku-Ladegerät 100 weist eine Ladeelektronik 70 auf, die innerhalb des Ladergehäuses 90 angeordnet ist. Die Ladeelektronik 70 ist ausgebildet, den in der Hauptladeschnittstelle 80 aufgenommenen Haupt-Werkzeugakku 10, der eine Nennspannung von 36 Volt aufweist, mit einer Hauptladespannung U10 zu laden.

Das netzbetreibbare Akku-Ladegerät 100 der Fig. 1 weist vorliegend eine erste Nebenladeschnittstelle 21 und eine zweite Nebenladeschnittstelle 31 auf. Die erste Nebenladeschnittstelle 21 ist über ein erstes Nebenladekabel 22 mit der Ladeelektronik 70 verbunden. Die zweite Nebenladeschnittstelle 31 ist über ein zweites Nebenladekabel 32 mit der Ladeelektronik 70 verbunden. Der in Fig. 1 gezeigte erste Neben-Werkzeugakku 20 ist vorliegend an die erste Nebenladeschnittstelle 21 angeschlossen und über diese mit einer ersten Nebenladespannung U20 ladbar. Der zweite Neben-Werkzeugakku 30, der über die zweite Nebenladeschnittstelle 31 mit dem Akku-Ladegerät 100 verbunden ist, ist über eine zweite Nebenladespannung U30 über das Akku-Ladegerät 100 ladbar. Die Hauptladespannung U10 ist von den Nebenladespannungen U20, U30 verschieden.

Vorliegend ist die Hauptladespannung U10 zum Laden des Haupt-Werkzeugakkus mit einer Nennspannung von 36 Volt eingerichtet. Die erste Nebenladespannung U20 ist zum Laden des ersten Neben-Werkzeugakkus mit einer Nennspannung von 22 Volt eingerichtet. Die zweite Nebenladespannung U30 ist zum Laden des zweiten Neben-Werkzeugakkus 30 mit einer Nennspannung von 14 Volt eingerichtet.

Wie ebenfalls aus Fig. 1 ersichtlich ist, ist die Hauptladeschnittstelle 80 über ein internes Ladekabel 71 mit der Ladeelektronik 70 verbunden. Sowohl die erste Nebenladeschnittstelle 21 als auch die zweite Nebenladeschnittstelle 31 sind elektrisch mit ein und derselben Ladeelektronik 70 wie die Hauptladeschnittstelle 80 verbunden.

Die Hauptladeschnittstelle 80 des Akku-Ladegeräts 100 ist ersichtlich direkt am Ladergehäuse 90 angeordnet. Über diese Hauptladeschnittstelle 80 ist der Haupt-Werkzeugakku, der eine Nennspannung von 36 Volt aufweist, ladbar. Hierzu kann der Haupt-Werkzeugakku in die Hauptladeschnittstelle 80 eingesteckt werden. Die erste Nebenladeschnittstelle 21 und die zweite Nebenladeschnittstelle 31 sind über das erste Nebenladekabel 21 beziehungsweise das zweite Nebenladekabel 31 vom Akku-Ladegerät 100 entfernt anordenbar. Vorliegend wird der erste Neben-Werkzeugakku 20, der eine Nennspannung von 22 Volt aufweist, entfernt von dem Akku-Ladegerät 100 aufgeladen. Ebenso wird der zweite Neben-Werkzeugakku 30, der eine Nennspannung von 14 Volt aufweist, entfernt von dem Akku-Ladegerät 100 aufgeladen. Weitere Nebenladeschnittstellen mit zusätzlichen Nebenladekabeln sind möglich.

Das netzbetreibbare Akku-Ladegerät 100 und der Haupt-Werkzeugakku 10, zu dessen Aufnahme die Hauptladeschnittstelle 10 des netzbetreibbaren Akku-Ladegeräts 100 ausgebildet ist, bilden vorliegend ein erfindungsgemäßes Ladesystem 500. Der erste Neben-Werkzeugakku 20 und/oder der zweite Neben-Werkzeugakku 30 können von dem Ladesystem 500 umfasst sein.

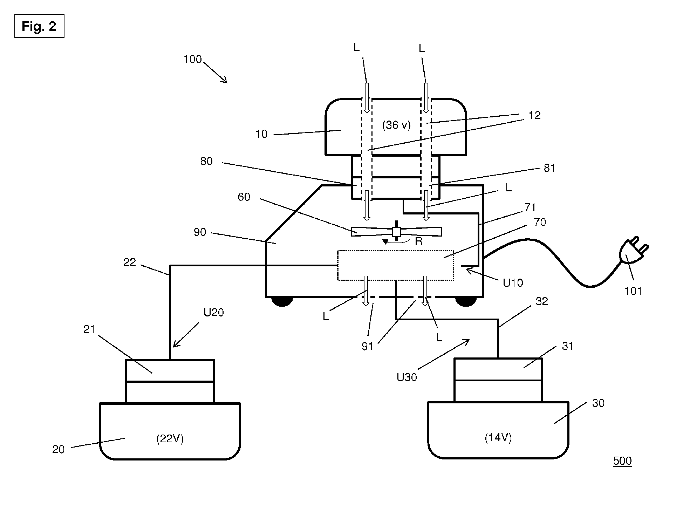

Das in Fig. 2 gezeigte Ausführungsbeispiel weist zusätzlich zu dem mit Bezug auf Fig. 1 beschriebenen Ausführungsbeispiel einen innerhalb des Ladergehäuses 90 angeordneten Kühlungslüfter 60 auf, der zum Kühlen der Ladeelektronik 70 des Akku-Ladegeräts 100 angeordnet ist. Die Hauptladeschnittstelle 80 des Akku-Ladegeräts 100 weist zwei Lüftungskanäle 81 auf, über die der in der Hauptladeschnittstelle 80 aufgenommene Haupt-Werkzeugakku mittels durch den Kühlungslüfter 60 angesaugter Luft L kühlbar ist. Der Haupt-Werkzeugakku 10 weist interne Akku-Lüftungskanäle 12 auf.

Im Ladebetrieb rotiert der Kühlungslüfter 60 des Akku-Ladegeräts 100 in einer Rotationsrichtung R. Dadurch wird Luft L durch die inneren Akku-Lüftungskanäle 12 in den Haupt-Werkzeugakku 10 eingesaugt und im Ladergehäuse 90 weiter in Richtung der Ladeelektronik 70 geführt, im weiteren Verlauf an dieser vorbeigeführt, um schließlich durch Auslassöffnungen 91 im Boden des Ladergehäuses 90 in die Umgebung ausgestoßen zu werden. Durch die Luft L wird somit sowohl der zu ladende Haupt-Werkzeugakku 10 als auch die den Haupt-Werkzeugakku 10 und die angeschlossenen Neben-Werkzeugakkus 20 und 30 ladende Ladeelektronik 70 gekühlt. Der Kühlungslüfter 60 wird derart betrieben, dass über die Luft eine erforderliche Abwärme sowohl aus dem Haupt-Werkzeugakku 10 als auch von der Ladeelektronik 70 weg abführbar ist.

Ein drittes Ausführungsbeispiel eines Akku-Ladegeräts 100 ist in Fig. 3 gezeigt, wobei das Akku-Ladegerät 100 lediglich von außen dargestellt ist. Das Akku-Ladegerät 100 weist ein Ladergehäuse 90 auf. Das Ladergehäuse weist eine zur auswechselbaren Aufnahme eines Haupt-Werkzeugakkus 10 ausgebildete Hauptladeschnittstelle 80 auf.

Das Akku-Ladegerät 100 weist eine erste Nebenladeschnittstelle 21 und eine zweite Nebenladeschnittstelle 31 auf. Die erste Nebenladeschnittstelle 21 ist vorliegend als Stecker ausgebildet. Ebenso ist die zweite Nebenladeschnittstelle 31 als Stecker ausgebildet. Über die erste Nebenladeschnittstelle 21 ist der in Fig. 3 gezeigte erste Neben-Werkzeugakku 20 mit einer ersten Nebenladespannung U20 ladbar. Über die zweite Nebenladeschnittstelle 31 ist ein zweiter Neben-Werkzeugakku, der vorliegend nicht dargestellt ist, über eine zweite Nebenladespannung U30 ladbar.

Wie aus Fig. 3 ersichtlich ist, ist die Hauptladeschnittstelle 80 lediglich zur Aufnahme des Haupt-Werkzeugakkus 10 mechanisch kodiert. Die erste Nebenladeschnittstelle 21 und die zweite Nebenladeschnittstelle 31 sind von der Hauptladeschnittstelle 80 mechanisch verschieden kodiert, da diese wie vorliegend gezeigt als Stecker zum Aufstecken auf einen Neben-Werkzeugakku ausgebildet sind.

### Bezugszeichenliste

- U10: Hauptladespannung
- U20: Erste Nebenladespannung
- U30: Zweite Nebenladespannung
- L: Luft
- R: Rotationsrichtung
- 10: Haupt-Werkzeugakku
- 12: Akku-Lüftungskanäle
- 20: erster Neben-Werkzeugakku
- 21: erste Nebenladeschnittstelle
- 22: erstes Nebenladekabel
- 30: zweiter Neben-Werkzeugakku
- 31: zweite Nebenladeschnittstelle
- 32: zweites Nebenladekabel
- 60: Kühlungslüfter
- 70: Ladeelektronik
- 71: internes Ladekabel
- 80: Hauptladeschnittstelle
- 81: Lüftungskanal
- 90: Ladergehäuse
- 91: Auslassöffnungen
- 100: Akku-Ladegerät
- 101: Netzstecker
- 500: Ladesystem

## Patentansprüche

1. Netzbetreibbares Akku-Ladegerät (100) mit einem Ladergehäuse (90), das eine zur auswechselbaren Aufnahme eines Haupt-Werkzeugakkus (10) einer Handwerkzeugmaschine ausgebildete Hauptladeschnittstelle (80) aufweist, und mit einer Ladeelektronik (70), die innerhalb des Ladergehäuses (90) angeordnet und ausgebildet ist, einen in der Hauptladeschnittstelle (80) aufgenommenen Haupt-Werkzeugakku (10) mit einer Hauptladespannung (U10) zu laden,
**dadurch gekennzeichnet, dass** das Akku-Ladegerät (100) wenigstens eine Nebenladeschnittstelle (21, 31) aufweist, über die ein Neben-Werkzeugakku (20, 30) mit dem Akku-Ladegerät (100) verbindbar und mit einer von der Hauptladespannung (U10) verschiedenen Nebenladespannung (U20, U30) ladbar ist.

2. Netzbetreibbares Akku-Ladegerät (100) nach Anspruch 1,
**dadurch gekennzeichnet, dass** die zur Aufnahme des Haupt-Werkzeugakkus (10) ausgebildete Hauptladeschnittstelle (80) und die mit einem Neben-Werkzeugakku (20, 30) verbindbare Nebenladeschnittstelle (21, 31) mechanisch verschieden kodiert sind, wobei Haupt-Werkzeugakku (10) und Neben-Werkzeugakku (20, 30) bevorzugt verschiedenen Typs sind.

3. Netzbetreibbares Akku-Ladegerät (100) nach Anspruch 1 oder 2,
**dadurch gekennzeichnet, dass** die Nebenladeschnittstelle (21, 31) als Stecker zum Aufstecken auf einen Neben-Werkzeugakku (20, 30) ausgebildet ist.

4. Netzbetreibbares Akku-Ladegerät (100) nach einem der vorangehenden Ansprüche,
**dadurch gekennzeichnet, dass** die Nebenladeschnittstelle (21, 31) elektrisch mit der gleichen Ladeelektronik (70) wie die Hauptladeschnittstelle (80) verbunden ist.

5. Netzbetreibbares Akku-Ladegerät (100) nach einem der vorangehenden Ansprüche,
**dadurch gekennzeichnet, dass** die Nebenladeschnittstelle (21, 31) über ein Nebenladekabel (22, 23) an das Akku-Ladegerät (100) angebunden sind.

6. Netzbetreibbares Akku-Ladegerät (100) nach einem der vorangehenden Ansprüche,
**dadurch gekennzeichnet, dass** die Hauptladespannung (U10) zum Laden eines Haupt-Werkzeugakkus (10) mit einer Nennspannung von 36 Volt eingerichtet ist.

7. Netzbetreibbares Akku-Ladegerät (100) nach einem der vorangehenden Ansprüche,
**dadurch gekennzeichnet, dass** die Nebenladespannung (U20, U30) zum Laden eines Werkzeugakkus (10) mit einer Nennspannung von 14 Volt oder 22 Volt eingerichtet ist.

8. Netzbetreibbares Akku-Ladegerät (100) nach einem der vorangehenden Ansprüche,
**dadurch gekennzeichnet, dass** das Akku-Ladegerät (100) einen innerhalb des Ladergehäuses (90) zum Kühlen der Ladeelektronik (70) angeordneten Kühlungslüfter (60) aufweist.

9. Netzbetreibbares Akku-Ladegerät (100) nach Anspruch 8,
**dadurch gekennzeichnet, dass** die Hauptladeschnittstelle (80) wenigstens einen Lüftungskanal (81) aufweist über den ein in der Hauptladeschnittstelle (80) aufgenommener Haupt-Werkzeugakku (10) mittels durch den Kühlungslüfter (60) angesaugter Luft (L) kühlbar ist.

10. Ladesystem (500) mit einem netzbetreibbaren Akku-Ladegerät nach einem der vorangehenden Ansprüche und Haupt-Werkzeugakku (10) zu dessen Aufnahme die Hauptladeschnittstelle (80) des netzbetreibbaren Akku-Ladegeräts (100) ausgebildet ist.
